# EUROPÄISCHE PATENTSCHRIFT

(11) **EP 3 706 160 B1**
(45) Veröffentlichungstag und Bekanntmachung des Hinweises auf die Patenterteilung: **14.07.2021**
(21) Anmeldenummer: 20000091.7
(22) Anmeldetag: 02.03.2020
(51) Int. Cl.: H01L 21/329, H01L 29/861, H01L 29/06

(54) **STAPELFÖRMIGE HOCHSPERRENDE III-V-LEISTUNGSHALBLEITERDIODE**
STACKED HIGH-BLOCKING-VOLTAGE III-V POWER SEMICONDUCTOR DIODE
DIODE EMPILÉE DE PUISSANCE À SEMI-CONDUCTEUR III-V À BLOCAGE ÉLEVÉ

(30) Priorität: 04.03.2019 DE 102019001459
(43) Veröffentlichungstag der Anmeldung: 09.09.2020
(73) Patentinhaber: 3-5 Power Electronics GmbH, 01217 Dresden (DE)
(72) Erfinder: Dudek, Volker, 76275 Ettlingen (DE)
(74) Vertreter: Koch Müller Patentanwaltsgesellschaft mbH

(56) Entgegenhaltungen:
- DE-A1-102016 013 540
- DE-A1-102016 013 541
- US-A1- 2013 015 469
- ZHANG S ET AL: "Epitaxial lateral overgrowths of GaAs on (001) GaAs substrates by LPE: Growth behavior and mechanism", JOURNAL OF CRYSTAL GROWTH, ELSEVIER, AMSTERDAM, NL, Bd. 99, Nr. 1-4, 1. Januar 1990 (1990-01-01), Seiten 292-296, XP027519322, ISSN: 0022-0248 [gefunden am 1990-01-01]

## Beschreibung

Die Erfindung betrifft eine stapelförmige hochsperrende III-V-Leistungshalbleiterdiode.

Aus "GaAs Power Devices" von German Ashkinazi, ISBN 965-7094-19-4, Seite 8 und 9 ist eine hochspannungsfeste Halbleiterdiode aus GaAs mit p+ - n - n+ bekannt. Auf den Seiten 23 bis 26 werden GaAs Schottky-Dioden beschrieben.

Weitere stapelförmige hochsperrende III-V-Leistungshalbleiterdioden und entsprechende Herstellungsverfahren sind auch aus den Druckschriften DE 10 2016 013 540 A1, DE 10 2016 013 541 A1, DE 10 2016 015 056 A1, DE 10 2017 002 935 A1 und DE 10 2017 002 936 A1 bekannt.

Aus S. Zang et al.: "Epitaxial lateral overgrowths of GaAs on (001) GaAs Substrates by LPE: Growth behavior and mechanism", Journal of Crystal Growth, Elsevier, Amsterdam, NL, Bd. 99, Nr. 1-4, 1990, S. 292-296, XP027519322, ist das Erzeugen einer GaAs-Schicht mittels epitaktischem lateralem Überwachsen (ELO) einer Maskenschicht mit Saatöffnungen bekannt.

Bei Dioden sollten Rest- bzw. Leckströme, die bei einem Betrieb in Sperrrichtung, insbesondere über die Ränder der planaren p-n Übergänge bzw. der Mesa-Strukturen auftreten, möglichst klein sein.

Vor diesem Hintergrund besteht die Aufgabe der Erfindung darin, eine Vorrichtung anzugeben, die den Stand der Technik weiterbildet. Ziel ist insbesondere eine Reduktion von Sperrströmen und eine Steigerung der Durchbruchspannung.

Die Aufgabe wird durch eine stapelförmige hochsperrende III-V-Leistungshalbleiterdiode mit den Merkmalen des Patentanspruchs 1 oder des Patentanspruchs 2 gelöst. Vorteilhafte Ausgestaltungen der Erfindung sind jeweils Gegenstand von Unteransprüchen.

Gemäß dem Gegenstand der Erfindung wird eine stapelförmige hochsperrende III-V-Leistungshalbleiterdiode bereitgestellt, aufweisend eine p+ Substratschicht mit einer Oberseite, einer Unterseite.

Die p+ Substratschicht umfasst eine GaAs-Verbindung oder besteht aus GaAs.

Des Weiteren ist eine p- Schicht mit einer Oberseite, einer Unterseite und eine n- Schicht mit einer Oberseite, einer Unterseite vorgesehen.

Die n-Schicht weist eine Schichtdicke von 10 µm - 150 µm oder insbesondere eine Schichtdicke zwischen 15 µm und 50 µm oder eine Schichtdicke zwischen 20 µm und 40 µm auf. Die p- Schicht und die n- Schicht umfassend jeweils eine GaAs-Verbindung oder bestehen aus GaAs.

Des Weiteren ist eine n+ Schicht mit einer Oberseite und einer Unterseite vorgesehen. Die n+ Schicht umfasst eine GaAs Verbindung oder besteht aus GaAs.

Auch sind eine erste metallische Kontaktschicht und eine zweite metallische Kontaktschicht vorgesehen, wobei die erste metallische Kontaktschicht mit der Unterseite der p+ Substratschicht und die zweite metallische Kontaktschicht ist mit der Oberseite der n+ Schicht stoffschlüssig verbunden.

Die Unterseite der n+ Schicht ist oberhalb der Oberseite der n- Bereich angeordnet. Vorzugsweise sind beide Schichten stoffschlüssig miteinander verbunden.

Vorzugsweise ist die Unterseite der p- Schicht zumindest mit einem Teil oder vollständig mit der Oberseite der p+ Substratschicht stoffschlüssig verbunden.

Vorzugsweise ist die Unterseite des n - Bereichs und die Oberseite der p-Schicht zumindest teilweise oder vollständig stoffschlüssig verbunden.

Außerdem weist die stapelförmige hochsperrende III-V-Leistungshalbleiterdiode eine Hartmaskenschicht mit einer Oberseite, einer Unterseite und mindestens einer Saatöffnung auf.

Die Unterseite der Hartmaskenschicht ist stoffschlüssig mit der Oberseite der p+ Substratschicht oder stoffschlüssig mit der Oberseite der p-Schicht verbunden.

Der n- Bereich erstreckt sich über einen an die Saatöffnung angrenzender Randbereich der Oberseite der Hartmaskenschicht und oberhalb und innerhalb der Saatöffnung ausgebildet ist.

Der n- Bereich ist mit der Oberseite der p- Schicht und in dem Randbereich der Oberseite der Hartmaskenschicht mit der Hartmaskenschicht stoffschlüssig verbunden. Insbesondere ist der n- Bereich innerhalb der Saatöffnung mit der p- Schicht stoffschlüssig verbunden.

Alternativ wird erfindungsgemäß eine stapelförmige hochsperrende III-V-Leistungshalbleiterdiode bereitgestellt, aufweisend eine n+-Substratschicht mit einer Oberseite, einer Unterseite. Die n+-Substratschicht umfasst eine GaAs-Verbindung oder besteht aus GaAs.

Ferner wird ein n- Bereich mit einer Oberseite, einer Unterseite bereitgestellt. Vorzugsweise weist der n-Bereich eine Schichtdicke von 10 µm - 150 µm oder vorzugsweise eine Schichtdicke zwischen 15 µm und 50 um oder vorzugsweise eine Schichtdicke zwischen 20 µm und 40 µm auf.

Der n- Bereich umfasst eine GaAs- Verbindung oder besteht aus GaAs.

Auf der Oberseite des n- Bereichs ist eine p- Schicht mit einer Oberseite, einer Unterseite angeordnet. Es versteht sich, dass die Unterseite der p- Schicht auf der Oberseite der n- Schicht angeordnet ist.

Die p- Schicht umfasst eine GaAs Verbindung oder besteht aus GaAs.

Des Weiteren ist eine p+ Schicht vorgesehen. Die p+ Schicht umfasst eine Oberseite und eine Unterseite. Die p+ Schicht umfasst eine GaAs Verbindung oder besteht aus GaAs.

Auch sind eine erste metallische Kontaktschicht und eine zweite metallische Kontaktschicht vorgesehen, wobei die erste metallische Kontaktschicht mit der Unterseite der n+ Substratschicht stoffschlüssig verbunden ist. Die zweite metallische Kontaktschicht ist stoffschlüssig mit der Oberseite der p+ Schicht verbunden.

Vorzugsweise sind die Unterseite des n- Bereichs und die Oberseite der n+ Substratschicht zumindest teilweise stoffschlüssig verbunden. Vorzugsweise ist die Unterseite der p- Schicht mit der Oberseite des n- Bereichs stoffschlüssig verbunden.

Vorzugsweise ist die Unterseite der p+ Schicht mit der Oberseite der p- Substratschicht stoffschlüssig verbunden.

Außerdem weist die stapelförmige hochsperrende III-V-Leistungshalbleiterdiode eine Hartmaskenschicht mit einer Oberseite und einer Unterseite auf und eine Saatöffnung auf.

Die Unterseite der Hartmaskenschicht ist stoffschlüssig mit der Oberseite der n+ Substratschicht verbunden.

Der n- Bereich erstreckt sich innerhalb der Saatöffnung und über einen an die Saatöffnung angrenzenden Randbereich der Oberseite der Hartmaskenschicht.

Innerhalb der Saatöffnung ist der n- Bereich stoffschlüssig mit der Oberseite der n+ Substratschicht verbunden. In dem Randbereich an der Oberseite der Hartmaske ist der n-Bereich auf der Hartmaske angeordnet und mit der Hartmaskenschicht stoffschlüssig verbunden.

Die erfindungsgemäße stapelförmige hochsperrende III-V-Leistungshalbleiterdiode lässt sich als eine n-auf-p Struktur oder als eine p-auf-n Struktur ausbilden. Es sei angemerkt, dass die jeweilige Substratschicht, d.h. die n+ Substratschicht oder die p+ Substratschicht, sowie die n+ Schicht für eine n auf p Struktur und die p+ Schicht für eine p auf n Struktur jeweils als hochdotierte Halbleiterkontaktschichten ausgebildet sind. Die Halbleiterkontaktschichten sind stoffschlüssig entweder mit der ersten metallischen Kontaktschicht oder mit der zweiten metallischen Kontaktschicht verbunden.

Anders ausgedrückt, die vorgenannten Halbleiterkontaktschichten sind möglichst hoch niederohmig ausgebildet, um in Vorwärtsrichtung, d.h. Durchlassrichtung, den Serienwiderstand und hierdurch die Verlustleistung der III-V-Leistungshalbleiterdiode zu reduzieren.

Es versteht sich, dass die metallischen Anschlussgebiete vollständig oder teilweise aus einem Metall, z.B. Gold, insbesondere aus einer Legierung bestehen.

Vorzugsweise lassen sich die metallischen Anschlussgebiete mittels Elektronenstrahlverdampfung oder mittels Sputtern oder bei dickeren Schichten auch galvanisch erzeugen.

Vorzugsweise sind die Halbleiterschichten der Halbleiterdiode wenigstens teilweise oder vollständig mittels MOVPE epitaktisch erzeugt. In einer alternativen Herstellungsweise sind die Schichten teilweise mittels Flüssigphasenepitaxie (LPE) hergestellt.

Es versteht sich, dass eine GaAs-Verbindung neben Gallium und Arsen sowie neben Dotierstoffen und/oder Verunreinigungen auch weitere Elemente der III oder V Hauptgruppe, z.B. Indium oder Aluminium umfassen kann.

Jedoch sei angemerkt, dass die Halbleiterschichten bzw. Halbleiterbereiche der erfindungsgemäßen III-V-Halbleiterdiode zumindest Gallium und Arsen umfassen oder aus Gallium und Arsen bestehen.

Vorzugsweise weisen die Schichten möglichst wenig Gitterversetzungen bzw. EL2 Zentren auf.

Für die Ausbildung der Saatöffnung wird die ganzflächige Hartmaskenschicht mittels eines Maskenprozesses strukturiert. Vorzugsweise umfasst oder besteht die Hartmaskenschicht aus SiO₂ und / oder aus Si₃N₄.

Ist die Substratschicht als p+ Substratschicht ausgebildet, so versteht es sich, dass die p- Schicht die Oberseite der p+ Substratschicht entweder ganzflächig oder nur innerhalb der Saatöffnung, z.B. durch Abscheiden nach Aufbringen der Hartmaskenschicht, überdeckt.

Beispielsweise wird die p- Schicht vor dem Aufbringen der Hartmaskenschicht auf der p+ Substratschicht ganzflächig aufgewachsen oder alternativ nach dem Aufbringen der Hartmaskenschicht innerhalb der Saatöffnung durch die selektive Epitaxie aufgewachsen.

Der n- Bereich, der das Driftgebiet der III-V-Halbleiterdiode ausbildet, wird innerhalb der Saatöffnung und sowohl in der Höhe als auch in der Breite über die Saatöffnung hinaus abgeschieden.

So ist die Höhe des n- Bereichs größer als die Tiefe der Saatöffnung bzw. die Dicke der Hartmaskenschicht.

Außerdem weist der n- Bereich innerhalb der Saatöffnung einen ersten Bereich mit einem ersten Durchmesser und oberhalb der Saatöffnung einen zweiten Bereich mit einem zweiten Durchmesser auf, wobei der erste Durchmesser dem Durchmesser der Saatöffnung entspricht und der zweite Durchmesser größer als der Durchmesser der Saatöffnung ist.

Hierdurch überdeckt der n- Bereich einen an die Saatöffnung angrenzenden Randbereich der Oberfläche der Hartmaskenschicht. Der Randbereich umschließt die Saatöffnung in einem Abstand zu der Saatöffnung, wobei der Abstand beispielsweise richtungsabhängig variieren kann, so dass der n- Bereich die Saatöffnung in einer Projektion senkrecht zu der Hartmaskenschicht zumindest überdeckt.

Das Überwachsen wird beispielsweise in einem gemeinsamen MOVPE oder LPE-Schritt mit dem Abscheiden der p- Schicht realisiert.

Die weiteren Schichten umschließen die sich an die Hartmaskenschicht anschließende Oberfläche des n- Bereichs bevorzugt vollständig oder zumindest im Wesentlichen. Anders ausgedrückt erstrecken sich die weiteren Schichten jeweils von der Oberseite der Hartmaskenschicht über den n- Bereich bis zu der Hartmaskenschicht.

Durch die Hartmaskenschicht werden Leckströme im Randbereich bzw. über den Rand verlaufende Strompfade unterdrückt.

Ein Vorteil der erfindungsgemäßen Halbleiterdiode ist eine besonders hohe Durchbruchspannung.

Gemäß einer Ausführungsform weist die p+ Substratschicht eine Dotierstoffkonzentration von 1•10¹⁸-5•10²⁰ cm⁻³ und eine Schichtdicke von 2 µm - 300 µm bzw. die n+ Substratschicht eine Dotierstoffkonzentration von mindestens 1• 10¹⁸ cm⁻³ und eine Schichtdicke von 2 µm - 300 µm auf, wobei die n+ Schicht eine Dotierstoffkonzentration von mindestens 1• 10¹⁸ cm⁻³ und eine Schichtdicke kleiner 30 µm bzw. die p+ Schicht eine Dotierstoffkonzentration von 5•10¹⁸-5•10²⁰ cm⁻³ und eine Schichtdicke kleiner 30 µm aufweist.

In einer anderen Ausführungsform überdeckt die n+ Schicht der n- Bereich vollständig oder zumindest zu 95% überdeckt und die zweite metallische Kontaktschicht die n+ Schicht vollständig oder zumindest zu 95% überdeckt bzw. die p+ Schicht überdeckt der n- Bereich vollständig oder zumindest zu 95% überdeckt und die zweite metallische Kontaktschicht die p+ Schicht vollständig oder zumindest zu 95%.

Gemäß einer anderen Ausführungsform weist der n- Bereich oberhalb der Hartmaskenschicht einen ersten Durchmesser und die Saatöffnung einen zweiten Durchmesser auf, wobei der erste Durchmesser mindestens um einen Faktor 1,5 größer als der zweite Durchmesser ist.

Durch ein ausreichendes Überwachsen, also einen möglichst breiten Randbereich um die Saatöffnung, der von der n- Bereich überdeckt wird, werden Leckströme reduziert oder vollständig verhindert.

Gemäß einer weiteren Ausführungsform ist die Saatöffnung rechteckig, z.B. viereckig oder quadratisch, ausgebildet und weist eine Breite und eine Länge auf.

In einer Weiterbildung verläuft die Breite der Saatöffnung parallel zu der Richtung <011> oder <001> oder <111> oder in einem Winkel von 15° oder von 30° zu der Richtung <011> oder zu der Richtung <001> oder zu der Richtung <111> der Substratschicht verläuft. Die Ausrichtung der Saatöffnung zu der darunterliegenden Schicht, insbesondere der Substratschicht beeinflusst den Grad des Überwachsens.

Gemäß einer anderen Weiterbildung ist die Oberseite der Substratschicht als GaAs (100)-Oberfläche oder GaAs (111)-Oberfläche ausgebildet.

In einer anderen Ausführungsform umfasst mindestens eine der p-dotierten Schichten Zink. Mindestens eine n-dotierte Schicht umfasst bevorzugt Silizium und/oder Chrom und/oder Palladium und/oder Zinn.

Gemäß einer weiteren Weiterbildung sind außer der Substratschicht alle Schichten der stapelförmigen III-V-Halbleiterdiode epitaktisch auf der jeweils vorausgehenden Schicht erzeugt, z.B. mittels LPE und MOVPE.

In einer weiteren Ausführungsform besteht die Hartmaskenschicht aus SiO₂ und / oder aus Si3N4. Es versteht sich, dass hierdurch nicht ausgeschlossen ist, dass die Hartmaskenschicht neben Si02 oder Si3N4 weitere Fremdatome, z.B. Verunreinigungen, oder Schichten aufweist.

Gemäß einer anderen Ausführungsform weist die Hartmaskenschicht eine Schichtdicke von 0,5 µm - 1 µm auf. Eine ausreichende Schichtdicke stellt sicher, dass Leckströme zuverlässig unterdrückt werden.

In einer anderen Weiterbildung ist auf der Oberseite der Hartmaskenschicht eine Leiterbahn angeordnet, wobei die Leiterbahn in einer elektrischen Wirkverbindung mit der zweiten metallischen Kontaktschicht steht. Beispielsweise ist die Leiterbahn umlaufend in Abstand zu Saatöffnung auf der Oberseite der Hartmaskenschicht angeordnet.

Die Leiterbahn ist beispielsweise zu der zweiten metallische Kontaktschicht beabstandet oder direkt an die zweite metallische Kontaktschicht angrenzend angeordnet. Dabei kann sich die zweite metallische Kontaktschicht auch über die Oberseite der Hartmaskenschicht erstrecken.

Die zweite metallische Kontaktschicht sowie die Leiterbahn können dabei sowohl zum Herstellen eines elektrischen Kontakts als auch zur Wärmeableitung dienen.

Gemäß einer weiteren Ausführungsform weist die p- Schicht eine Dotierstoffkonzentration von 1•10¹⁴ - 1•10¹⁷ cm⁻³ und eines Schichtdicke von 1 µm - 40 µm auf. Der n- Bereich weist bevorzugt eine Dotierstoffkonzentration von 8•10¹³ - 1•10¹⁶ cm⁻³ auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Schichtansicht einer ersten Ausführungsform einer stapelförmigen III-V-Halbleiterdiode,
- Figur 2: eine Schnittansicht einer zweiten Ausführungsform einer stapelförmigen III-V-Halbleiterdiode,
- Figur 3: eine Schnittansicht einer dritten Ausführungsform einer stapelförmigen III-V-Halbleiterdiode
- Figur 4a-c: Schnittansichten von Metallisierungsvarianten der stapelförmigen III-V-Halbleiterdiode nach einen der Ausführungsformen, dargestellt in Zusammenhang mit den Figuren 1 bis 3.

Bei allen Abbildungen ist aus Gründen der Übersichtlichkeit jeweils nur eine Schnittansicht bzw. Querschnittsansicht einer III-V-Halbleiterdiode 10 dargestellt. Es sei jedoch angemerkt, dass alle in der Schnittansicht abgebildeten III-V-Halbleiterdiode 10 in einer Draufsicht entweder einen quadratischen oder einen rechteckigen oder einen runden Umfang aufweisen.

Anders ausgedrückt, in der Draufschicht weisen die III-V-Halbleiterdioden die gleichen Schichtfolgen als in der jeweiligen Querschnittsansicht auf. Des Weiteren gilt für alle dargestellten Ausführungsformen, dass die III-V-Halbleiterdiode 10 eine Oberseite und eine Unterseite aufweisen, wobei vorzugsweise mittels einer an der Unterseite ausgebildeten metallischen Anschlusskontaktschicht die III-V-Halbleiterdioden als sogenanntes "DIE" auf einer als Metallrahmen bzw. Metallträger auch "Leadframe" genanntem Unterlage angeordnet sind. Eine möglichst große insbesondere ganzflächige Ausbildung der metallischen Anschlusskontaktschicht verbessert die thermische Ankopplung an die Unterlage.

Des Weiteren sei angemerkt, dass alle ausgehend von der Unterseite der III-V-Halbleiterdiode die ausgebildeten Halbleiterschichten planar ausgebildet sind.

Auch sei angemerkt, dass an der Unterseite der III-V-Halbleiterdioden in allen dargestellten Ausführungsformen eine Substratschicht, d.h. entweder ein p+ Substratschicht oder eine n+ Substratschicht ausgebildet ist. Es versteht sich, dass die Substratschicht im Ausgangszustand eine Dicke zwischen 400 µm um 700 µm aufweist, abhängig von der Größe der Ausgangshalbeitersubstratscheibe. Anders ausgedrückt eine 3-Zoll Halbleitersubstratscheibe weist im Allgemeinen eine geringe Dicke als eine 6-Zoll Halbleitersubstratscheibe.

Um den Serienwiderstand in Vorwärtsrichtung zu reduzieren, wird vor der Ausbildung der metallischen Anschlusskontaktschicht die Halbleitersubstratscheibe gedünnt, wobei aus Gründen der mechanischen Stabilität die Restdicke vorzugsweise in einem Bereich zwischen 80 µm und 200 µm oder vorzugsweise in einem Bereich zwischen 120 µm und 150 µm liegt.

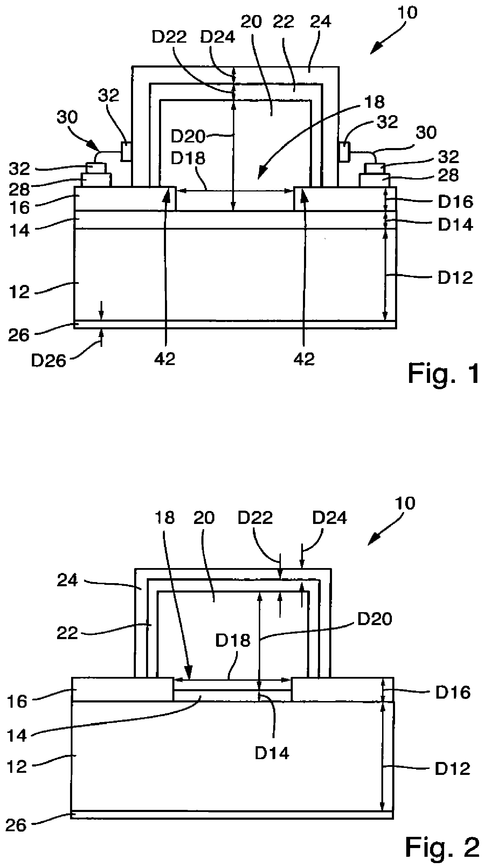

Die Abbildung der Figur 1 zeigt eine erste Ausführungsform der stapeiförmigen III-V-Haibleiterdiode 10 mit einer n- auf -p Struktur. Hierbei sind die n-dotierten Halbleiterschichten oberhalb der p- dotierten Halbleiterschichten ausgebildet.

Auf einer Oberseite einer p+ Substratschicht 12 mit einer Schichtdicke D12 ist ganzflächig eine p- Schicht 14 mit einer Schichtdicke D14 angeordnet. Auf einer Oberseite der p- Schicht 14 ist eine Hartmaskenschicht 16 mit einer Schichtdicke D16 und einer Saatöffnung 18 mit einer Breite D18 und einer nicht dargestellten Länge (in die Bildebene hinein bzw. heraus) angeordnet.

Innerhalb der Saatöffnung 18 auf der Oberseite der p- Schicht 14 ist ein n-Bereich 20 mit einer Höhe D20 angeordnet, wobei sich der n- Bereich 20 sich auch über einen an die Saatöffnung angrenzenden Randbereich 22 einer Oberseite der Hartmaskenschicht 18 erstreckt. Es versteht sich, dass der Randbereich 22 um die Saatöffnung 18 herum verläuft, sich der n- Bereich 20 als in alle Richtungen über die Saatöffnung 18 hinaus über einen Teil der Oberseite der Hartmaskenschicht 16 erstreckt.

Eine sich an die Hartmaskenschicht 16 anschließende Oberfläche des n- Bereichs 20 ist von einer n+ Schicht 22 mit einer Schichtdicke D22 bedeckt bzw. umschlossen. Die n+ Schicht 22 ist wiederum von einer zweiten metallischen Kontaktschicht 24 mit einer Schichtdicke D24 vorzugsweise vollständig bedeckt bzw. umschlossen.

Eine erste metallische Kontaktschicht 26 mit einer Schichtdicke D26 ist flächig auf einer Unterseite der p+ Substratschicht 12 ausgebildet. Vorzugsweise überdeckt die metallische Kontaktschicht 26 die Unterseite der p+ Substratschicht 12 ganzflächig oder wenigstens zu mehr als 90% der Fläche. Hierdurch wird bei hohen Strombelastungen die Wärmeabfuhr verbessert.

Umlaufend um die Saatöffnung 18 und in einem Abstand zu der Saatöffnung 18 und der zweiten metallischen Kontaktschicht 24 ist eine Leiterbahn 28 angeordnet, wobei die Leiterbahn 28 über mindestens einen Kontaktdraht 30 mit der zweiten metallischen Kontaktschicht 24 in einer elektrischen Wirkverbindung steht. Auf der Leiterbahn 28 und auf der zweiten Kontaktschicht ist hierzu jeweils eine Bondierungsfläche 32 für den Anschluss des Kontaktdrahtes 30 ausgebildet.

In der Abbildung der Figur 2 ist eine zweite Ausführungsform der Halbleiterdiode 10 dargestellt. Im Folgenden werden nur die Unterschiede zu der Abbildung der Figur 1 erläutert.

Die p- Schicht 14 der Halbleiterdiode 10 erstreckt sich nur über den von der Hartmaskenschicht 16 ausgesparten Bereich der Oberseite der p+ Substratschicht 12. Die n- Schicht 14 ist also innerhalb der Saatöffnung 18 ausgebildet.

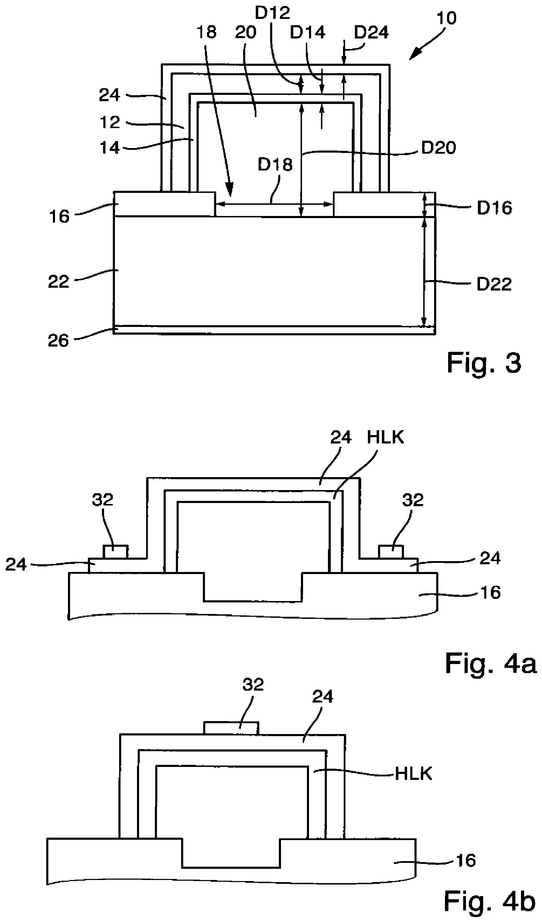

In der Abbildung der Figur 3 ist eine dritte Ausführungsform dargestellt. Im Folgenden werden nur die Unterschiede zu der Abbildung der Figur 1 erläutert.

Die stapelförmigen III-V-Halbleiterdiode 10 weist eine p- auf -n Struktur auf, d.h. die n+ Schicht 22 ist als n+ Substratschicht 22 mit einer Schichtdicke D22 ausgebildet und die Hartmaskenschicht 16 mit der Schichtdicke D16 ist auf der Oberseite der n+ Substratschicht 22 angeordnet.

Die p- Schicht 14 mit der Schichtdicke D14 überdeckt die Oberseite des n-Bereichs 20, gefolgt von der p+ Schicht 12 mit der Schichtdicke D12 und der zweiten metallischen Kontaktschicht 24 mit der Schichtdicke D24.

Ein Vorteil der Ausführung der p- auf n Struktur ist es, dass sich die elektrischen Eigenschaften der III-V-Halbleiterdiode 10 verbessern, indem der elektrische Widerstand der n+ Schicht wenigstens um einen Faktor 5 bis zu einem Faktor 10 geringer als der der p+ Schicht ist. Insbesondere ist der Effekt auf die großen Unterschiede der effektiven Masse der Löcher im Vergleich zu den Elektronen zurückzuführen.

Die Abbildungen 4a-c zeigen jeweils Schnittansichten von insgesamt drei unterschiedlichen Ausbildungen der zweiten Kontaktschicht 24 der stapeiförmigen III-V-Halbleiterdiode 10. Aus Gründen der Übersichtlichkeit sind jeweils nur ein Teil der Halbleiterschichten dargestellt. Stellvertretend für die n+ Schicht oder die p+ Schicht ist eine Halbleiterkontaktschicht HLK mit einer Oberseite und einer Unterseite ausgebildet.

Die Oberseite der Halbleiterkontaktschicht HLK ist bei allen drei Ausbildungen stoffschlüssig mit der zweiten metallischen Kontaktschicht 24 verbunden.

Auf der Oberseite der zweiten Kontaktschicht 24 ist jeweils zumindest eine Bondierungsfläche 32 ausgebildet. Auf den Bondierungsflächen lässt sich ein Kontaktdraht, der auch als Bonddraht bezeichnet wird, anschließen- nicht dargestellt.

In der Ausführungsform der Figur 4a umschließt die zweite Kontaktschicht 24 in einen ersten Bereich nicht nur die Halbleiterkontaktschicht HLK vollständig, sondern ist auch in einem zweiten Bereich auch auf der Oberseite der Hartmaskenschicht 16 umlaufend ausgebildet. In dem zweiten Bereich sind auf der Oberseite der zweiten Kontaktschicht 24 zwei Bondierungsfläche 32 ausgebildet. Auf den Bondierungsflächen lässt sich ein Kontaktdraht auch als Bonddraht bezeichnet anschließen- nicht dargestellt.

In der Ausführungsform der Figur 4b umschließt die zweite Kontaktschicht 24 in einen ersten Bereich die Halbleiterkontaktschicht HLK. Auf der Oberseite der zweiten Kontaktschicht 24 ist die Bondierungsfläche 32 ausgebildet.

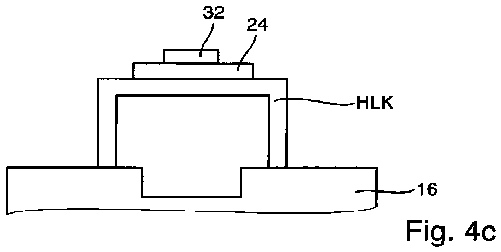

In der Ausführungsform der Figur 4c ist die zweite Kontaktschicht 24 in einen ersten Bereich nur auf der Deckfläche der Halbleiterkontaktschicht HLK ausgebildet, d.h. an den Seitenflächen der Halbleiterkontaktschicht HLK ist die zweite Kontaktschicht 24 nicht ausgebildet. Auf der Oberseite von der an der Deckfläche ausgebildeten zweiten Kontaktschicht 24 ist die Bondierungsfläche 32 ausgebildet.

## Patentansprüche

1. Stapelförmige hochsperrende III-V-Leistungshalbleiterdiode (10), aufweisend
- eine p+ Substratschicht (12) mit einer Oberseite, einer Unterseite und eine GaAs-Verbindung umfassend oder aus GaAs bestehend,
- eine p- Schicht (14) mit einer Oberseite, einer Unterseite und eine GaAs-Verbindung umfassend oder aus GaAs bestehend,
- einen n- Bereich (20) mit einer Oberseite, einer Unterseite, einer Schichtdicke (D20) von 10 µm - 150 µm und eine GaAs-Verbindung umfassend oder aus GaAs bestehend,
- eine n+ Schicht (22) mit einer Oberseite, einer Unterseite und eine GaAs-Verbindung umfassend oder aus GaAs bestehend,
- eine erste metallische Kontaktschicht (26) und eine zweite metallische Kontaktschicht (24), wobei
- die erste metallische Kontaktschicht (26) mit der Unterseite der p+ Substratschicht (12) stoffschlüssig verbunden ist,
- die zweite metallische Kontaktschicht (24) mit der Oberseite der n+ Schicht (22) stoffschlüssig verbunden ist,
wobei die Unterseite der n+ Schicht oberhalb des n- Bereichs angeordnet ist und die Unterseite der p- Schicht auf der Oberseite der-p+ Substratschicht angeordnet ist,
**dadurch gekennzeichnet, dass**
- eine Hartmaskenschicht (16) mit einer Oberseite, einer Unterseite und mindestens einer Saatöffnung (18) vorgesehen ist, wobei
- die Unterseite der Hartmaskenschicht (16) stoffschlüssig mit der Oberseite der p+ Substratschicht (12) oder stoffschlüssig mit der Oberseite der p- Schicht (14) verbunden ist, und
- der n- Bereich (20) sich über einen an die Saatöffnung (18) angrenzenden Randbereich (42) der Oberseite der Hartmaskenschicht (16) und oberhalb und Innerhalb der Saatöffnung (18) erstreckt und
- der n- Bereich (20) innerhalb der Saatöffnung (18) mit der Oberseite der p- Schicht (14) und in dem Randbereich (42) auf der Oberseite der Hartmaskenschicht (16) mit der Hartmaskenschicht (16) stoffschlüssig verbunden ist.

2. Stapelförmige hochsperrende III-V-Leistungshalblelterdiode (10), aufweisend
- eine n+ Substratschicht (22) mit einer Oberseite, einer Unterseite und eine GaAs-Verbindung umfassend oder aus GaAs bestehend,
- einen n- Bereich (20) mit einer Oberseite, einer Unterseite, einer Schichtdicke (D20) von 10 µm - 150 µm und eine GaAs-Verbindung umfassend oder aus GaAs bestehend,
- eine p- Schicht (14) mit einer Oberseite, einer Unterseite und eine GaAs-Verbindung umfassend oder aus GaAs bestehend,
- eine p+ Schicht (12) mit einer Oberseite, einer Unterseite und eine GaAs Verbindung umfassend oder aus GaAs bestehend,
- eine erste metallische Kontaktschicht (26) und eine zweite metallische Kontaktschicht (24), wobei
- die erste metallische Kontaktschicht (26) mit der Unterseite der n+ Substratschicht (22) stoffschlüssig verbunden ist,
- die Unterseite der n- Bereich (20) oberhalb der Oberseite der n+ Substratschicht (22) angeordnet ist,
- die zweite metallische Kontaktschicht (24) mit der Oberseite der p+ Schicht (12) stoffschlüssig verbunden ist,
wobei die Unterseite der p- Schicht auf der Oberseite der n- Schicht angeordnet ist und die Unterseite der p+ Schicht auf der Oberseite der p-Schicht angeordnet ist,
**dadurch gekennzeichnet, dass**
- eine Hartmaskenschicht (16) mit einer Oberseite, einer Unterseite und mindestens einer Saatöffnung (18) vorgesehen ist, wobei
- die Unterseite der Hartmaskenschicht (16) stoffschlüssig mit der Oberseite der n+ Substratschicht (22) verbunden ist,
- der n- Bereich (20) sich innerhalb der Saatöffnung (18) und über einen an die Saatöffnung (18) angrenzender Randbereich (42) der Oberseite der Hartmaskenschicht (16) erstreckt, und
- der n- Bereich (20) innerhalb der Saatöffnung (18) mit der Oberseite der n+ Substratschicht (22) und in dem Randbereich (42) der Oberseite der Hartmaskenschicht mit der Hartmaskenschicht stoffschlüssig verbunden ist.

3. Stapelförmige hochsperrende III-V-Leistungshalbleiterdiode (10) nach Anspruch 1 **dadurch gekennzeichnet, dass** die p+ Substratschicht (12) eine Dotierstoffkonzentration von 5•10¹⁸-5•10²⁰ cm⁻³ und eine Schichtdicke (D12) von 5 µm - 300 µm aufweist.

4. Stapelförmige hochsperrende III-V-Leistungshalbleiterdiode (10) nach Anspruch 1 oder 3 **dadurch gekennzeichnet, dass** die n+ Schicht (22) eine Dotierstoffkonzentration von mindestens 1• 10¹⁸ cm⁻³ und eine Schichtdicke (D22) kleiner 30 µm aufweist.

5. Stapelförmige hochsperrende III-V-Leistungshalbleiterdiode (10) nach Anspruch 1 oder 3 oder 4 **dadurch gekennzeichnet, dass** die n+ Schicht (22) der n- Bereich (20) vollständig oder zumindest zu 95% überdeckt und die zweite metallische Kontaktschicht (24) die n+ Schicht (22) vollständig oder zumindest zu 95% überdeckt.

6. Stapelförmige hochsperrende III-V-Leistungshalbleiterdiode (10) nach Anspruch 2 **dadurch gekennzeichnet, dass** die n+ Substratschicht (22) eine Dotierstoffkonzentration von mindestens 1• 10¹⁸ cm⁻³ und eine Schichtdicke (D22) von 5 µm - 300 µm aufweist.

7. Stapelförmige hochsperrende III-V-Leistungshalbleiterdiode (10) nach Anspruch 2 oder 6 **dadurch gekennzeichnet, dass** die p+ Schicht (12) eine Dotierstoffkonzentration von 5•10¹⁸-5•10²⁰ cm⁻³ und eine Schichtdicke (D12) kleiner als 30 µm aufweist.

8. Stapelförmige hochsperrende III-V-Lelstungshalbleiterdiode (10) nach Anspruch 2 oder 6 oder 7 **dadurch gekennzeichnet, dass** die p+ Schicht (12) den n- Bereich (20) vollständig oder zumindest zu 95% überdeckt und die zweite metallische Kontaktschicht (24) die p+ Schicht (12) vollständig oder zumindest zu 95% überdeckt.

9. Stapelförmige hochsperrende III-V-Leistungshalbleiterdiode (10) nach einem der vorangegangenen Ansprüche, **dadurch gekennzeichnet, dass** der n- Bereich (20) oberhalb der Hartmaskenschicht (16) einen ersten Durchmesser und die Saatöffnung (18) einen zweiten Durchmesser aufweist, wobei der erste Durchmesser mindestens um einen Faktor 1,5 größer als der zweite Durchmesser ist.

10. Stapelförmige hochsperrende III-V-Leistungshalbleiterdiode (10) nach einem der vorangegangenen Ansprüche, **dadurch gekennzeichnet, dass** die Saatöffnung (18) rechteckig ausgebildet ist und eine Breite (D18) und eine Länge aufweist.

11. Stapelförmige hochsperrende III-V-Leistungshalbleiterdiode (10) nach Anspruch 6, **dadurch gekennzeichnet, dass** die Breite der Saatöffnung (18) parallel zu der Richtung <011> oder <001> oder <111> oder in einem Winkel von 15° oder von 30° zu der Richtung <011> oder zu der Richtung <001> oder zu der Richtung <111> der Substratschicht verläuft.

12. Stapelförmige hochsperrende III-V-Leistungshalbleiterdiode (10) nach einem der vorangegangenen Ansprüche, **dadurch gekennzeichnet, dass** die Oberseite der Substratschicht als GaAs(100)-Oberfläche oder GaAs(111)-Oberfläche ausgebildet ist.

13. Stapelförmige hochsperrende III-V-Leistungshalbleiterdiode (10) nach einem der vorangegangenen Ansprüche, **dadurch gekennzeichnet, dass** mindestens eine der p-dotierten Schichten Zink umfasst.

14. Stapelförmige hochsperrende III-V-Leistungshalbleiterdiode (10) nach einem der vorangegangenen Ansprüche, **dadurch gekennzeichnet, dass** mindestens eine der n-dotierten Schichten Silizium und/oder Chrom und/oder Palladium und/oder Zinn umfasst.

15. Stapelförmige hochsperrende III-V-Leistungshalbleiterdiode (10) nach einem der vorangegangenen Ansprüche, **dadurch gekennzeichnet, dass** außer der Substratschicht alle Schichten der stapelförmigen III-V-Halbleiterdiode epitaktisch auf der jeweils vorausgehenden Schicht erzeugt sind.

16. Stapelförmige hochsperrende III-V-Leistungshalbleiterdiode (10) nach einem der vorangegangenen Ansprüche, **dadurch gekennzeichnet, dass** die Hartmaskenschicht (16) aus Si02 und / oder aus Si3N4 besteht.

17. Stapelförmige hochsperrende III-V-Leistungshalbleiterdlode (10) nach einem der vorangegangenen Ansprüche, **dadurch gekennzeichnet, dass** die Hartmaskenschicht (16) eine Schichtdicke von 0,1 µm - 5 µm aufweist.

18. Stapelförmige hochsperrende III-V-Leistungshalbleiterdiode (10) nach einem der vorangegangenen Ansprüche, **dadurch gekennzeichnet, dass** auf der Oberseite der Hartmaskenschicht (16) eine Leiterbahn (28) angeordnet ist und die Leiterbahn (28) mit der zweiten metallischen Kontaktschicht (24) verbunden ist.

19. Stapelförmige hochsperrende III-V-Leistungshalbleiterdiode (10) nach einem der vorangegangenen Ansprüche, **dadurch gekennzeichnet, dass** die p- Schicht (14) eine Dotierstoffkonzentration von 1•10¹⁴ - 1•10¹⁷ cm⁻³ und eine Schichtdicke (D14) von 1 µm - 20 µm aufweist.

20. Stapelförmige hochsperrende III-V-Leistungshalblelterdiode (10) nach einem der vorangegangenen Ansprüche, **dadurch gekennzeichnet, dass** der n- Bereich (20) eine Dotierstoffkonzentration von 8•10¹³ - 1•10¹⁶ cm⁻³ aufweist.

## Claims

1. Stacked high-blocking-voltage III-V power semiconductor diode (10), comprising
- a p+ substrate layer (12) with an upper side, a lower side and comprising a GaAs compound or consisting of GaAs,
- a p- layer (14) with an upper side, a lower side and comprising a GaAs compound or consisting of GaAs,
- an n- region (20) with an upper side, a lower side, a layer thickness (D20) of 10 µm
- 150 µm and comprising a GaAs compound or consisting of GaAs,
- an n+ layer (22) with an upper side, a lower side and comprising a GaAs compound or consisting of GaAs,
- a first metallic contact layer (26) and a second metallic contact layer (24), wherein
- the first metallic contact layer (26) is connected by material couple with the lower side of the p+ substrate layer (12),
- the second metallic contact layer (24) is connected by material couple with the upper side of the n+ layer (22),
wherein the lower side of the n+ layer is arranged above the n- region and the lower side of the p- layer is arranged on the upper side of the p+ substrate layer,
**characterised in that**
- a hard mask layer (16) with an upper side, a lower side and at least one seed opening (18) is provided, wherein
- the lower side of the hard mask layer (16) is connected by material couple with the upper side of the p+ substrate layer (12) or by material couple with the upper side of the player (14) and
- the n- region (20) extends over an edge region (42), which adjoins the seed opening (18), of the upper side of the hard mask layer (16) and above and within the seed opening (18) and
- the n- region (20) is connected by material couple with the upper side of the player (14) within the seed opening (18) and with the hard mask layer (16) in the edge region (42) on the upper side of the hard mask layer (16).

2. Stacked high-blocking-voltage III-V power semiconductor diode (10), comprising
- an n+ substrate layer (22) with an upper side, a lower side and comprising a GaAs compound or consisting of GaAs,
- an n- region (20) with an upper side, a lower side, a layer thickness (D20) of 10 µm
- 150 µm and comprising a GaAs compound or consisting of GaAs,
- a p- layer (14) with an upper side, a lower side and comprising a GaAs compound or consisting of GaAs,
- a p+ layer (12) with an upper side, a lower side and comprising a GaAs compound or consisting of GaAs,
- a first metallic contact layer (26) and a second metallic contact layer (24), wherein
- the first metallic contact layer (26) is connected by material couple with the lower side of the n+ substrate layer (22),
- the lower side of the n- region (20) is arranged above the upper side of the n+ substrate layer (22),
- the second metallic contact layer (24) is connected by material couple with the upper side of the p+ layer (12),
wherein the lower side of the p- layer is arranged on the upper side of the n- layer and the lower side of the p+ layer is arranged on the upper side of the p- layer,
**characterised in that**
- a hard mask layer (16) with an upper side, a lower side and at least one seed opening (18) is provided, wherein
- the lower side of the hard mask layer (16) is connected by material couple with the upper side of the n+ substrate layer (22),
- the n- region (20) extends within the seed opening (18) and over an edge region (42), which adjoins the seed opening (18), of the upper side of the hard mask layer (16) and
- the n- region (20) is connected by material couple within the seed opening (18) with the upper side of the n+ substrate layer (22) and with the hard mask layer in the edge region (42) of the upper side of the hard mask layer.

3. Stacked high-blocking-voltage III-V power semiconductor diode (10) according to claim 1, **characterised in that** the p+ substrate layer (12) has a doping substance concentration of 5•10¹⁸ - 5•10²⁰ cm⁻³ and a layer thickness (D12) of 5 µm - 300 µm.

4. Stacked high-blocking-voltage III-V power semiconductor diode (10) according to claim 1 or 3, **characterised in that** the n+ layer (22) has a doping substance concentration of at least 1•10¹⁸ cm⁻³ and a layer thickness (D22 of less than 30 µm.

5. Stacked high-blocking-voltage III-V power semiconductor diode (10) according to claim 1 or 3 or 4, **characterised in that** the n+ layer (22) covers the n- region (20) completely or at least to 95% and the second metallic contact layer (24) covers the n+ layer (22) completely or at least to 95%.

6. Stacked high-blocking-voltage III-V power semiconductor diode (10) according to claim 2, **characterised in that** the n+ substrate layer (22) has a doping substance concentration of at least 1•10¹⁸ cm⁻³ and a layer thickness (D22) of 5 µm - 300 µm.

7. Stacked high-blocking-voltage III-V power semiconductor diode (10) according to claim 2 or 6, **characterised in that** the p+ layer (12) has a doping substance concentration of 5•10¹⁸ - 5•10²⁰ cm⁻³ and a layer thickness (D12) of less than 30 µm.

8. Stacked high-blocking-voltage III-V power semiconductor diode (10) according to claim 2 or 6 or 7, **characterised in that** the p+ layer (12) covers the n- region (20) completely or at least to 95% and the second metal contact layer (24) covers the p+ layer (12) completely or at least to 95%.

9. Stacked high-blocking-voltage III-V power semiconductor diode (10) according to any one of the preceding claims, **characterised in that** the n- region (20) above the hard mask layer (16) has a first diameter and the seed opening (18) has a second diameter, wherein the first diameter is greater than the second diameter by at least a factor of 1.5.

10. Stacked high-blocking-voltage III-V power semiconductor diode (10) according to any one of the preceding claims, **characterised in that** the seed opening (18) is of rectangular form and has a width (D18) and a length.

11. Stacked high-blocking-voltage III-V power semiconductor diode (10) according to claim 6, **characterised in that** the width of the seed opening (18) extends parallel to the direction <011> or <001> or <111> or at an angle of 15° or of 30° to the direction <011> or to the direction <001> or to the direction <111 > of the substrate layer.

12. Stacked high-blocking-voltage III-V power semiconductor diode (10) according to any one of the preceding claims, **characterised in that** the upper side of the substrate layer is formed as a GaAs(100) surface or GaAs(111) surface.

13. Stacked high-blocking-voltage III-V power semiconductor diode (10) according to any one of the preceding claims, **characterised in that** at least one of the p- doped layers comprises zinc.

14. Stacked high-blocking-voltage III-V power semiconductor diode (10) according to any one of the preceding claims, **characterised in that** at least one of the n- doped layers comprises silicon and/or chromium and/or palladium and/or tin.

15. Stacked high-blocking-voltage III-V power semiconductor diode (10) according to any one of the preceding claims, **characterised in that** apart from the substrate layer all layers of the stacked III-V semiconductor dioide are produced epitaxially on the respective preceding layer.

16. Stacked high-blocking-voltage III-V power semiconductor diode (10) according to any one of the preceding claims, **characterised in that** the hard mask layer (16) consists of SiO₂ and/or of Si₃N₄.

17. Stacked high-blocking-voltage III-V power semiconductor diode (10) according to any one of the preceding claims, **characterised in that** the hard mask layer (16) has a layer thickness of 0.1 µm - 5 µm.

18. Stacked high-blocking-voltage III-V power semiconductor diode (10) according to any one of the preceding claims, **characterised in that** a conductor track (28) is arranged on the upper side of the hard mask layer (16) and the conductor track (28) is connected with the second metallic contact layer (24).

19. Stacked high-blocking-voltage III-V power semiconductor diode (10) according to any one of the preceding claims, **characterised in that** the p- layer (14) has a doping substance concentration of 1•10¹⁴ - 1•10¹⁷ cm⁻³ and a layer thickness (D14) of 1 µm - 20 µm.

20. Stacked high-blocking-voltage III-V power semiconductor diode (10) according to any one of the preceding claims, **characterised in that** the n- region (20) has a doping substance concentration of 8•10¹³ -1•10¹⁶ cm⁻³.

## Revendications

1. Diode en forme de pile à semi-conducteur de puissance III-V à blocage élevé (10), comprenant
- une couche de substrat p+ (12) présentant une face supérieure, une face inférieure et comprenant un composé GaAs ou constituée de GaAs,
- une couche p- (14) présentant une face supérieure, une face inférieure et comprenant un composé GaAs ou constituée de GaAs,
- une zone n- (20) présentant une face supérieure, une face inférieure, une épaisseur de couche (D20) qui est comprise entre 10 µm et 150 µm et comprenant un composé GaAs ou constituée de GaAs,
- une couche n+ (22) présentant une face supérieure, une face inférieure et comprenant un composé GaAs ou constituée de GaAs, et
- une première couche de contact métallique (26) et une deuxième couche de contact métallique (24), dans laquelle
- la première couche de contact métallique (26) est reliée par liaison de matière à la face inférieure de la couche de substrat p+ (12),
- et la deuxième couche de contact métallique (24) est reliée par liaison de matière à la face supérieure de la couche n+ (22), et
dans laquelle la face inférieure de la couche n+ est disposée au-dessus de la zone n- et la face inférieure de la couche p- est disposée sur la face supérieure de la couche de substrat p+,
**caractérisée en ce que**
- une couche de masque dur (16) présentant une face supérieure, une face inférieure et au moins une ouverture de semence (18) est prévue,
- dans laquelle la face inférieure de la couche de masque dur (16) est reliée par liaison de matière à la face supérieure de la couche de substrat p+ (12) ou par liaison de matière à la face supérieure de la couche p- (14),
- la zone n- (20) s'étend sur une zone de bord (42) de la face supérieure de la couche de masque dur (16) à proximité de l'ouverture de semence (18) et au-dessus et à l'intérieur de l'ouverture de semence (18), et
- la zone n- (20) à l'intérieur de l'ouverture de semence (18) est reliée par liaison de matière à la face supérieure de la couche p- (14) et dans la zone de bord (42) sur la face supérieure de la couche de masque dur (16) à la couche de masque dur (16).

2. Diode en forme de pile à semi-conducteur de puissance III-V à blocage élevé (10), comprenant
- une couche de substrat n+ (22) présentant une face supérieure, une face inférieure et comprenant un composé GaAs ou constituée de GaAs,
- une zone n- (20) présentant une face supérieure, une face inférieure, une épaisseur de couche (D20) qui est comprise entre 10 µm et 150 µm et comprenant un composé GaAs ou constituée de GaAs,
- une couche p- (14) présentant une face supérieure, une face inférieure et comprenant un composé GaAs ou constituée de GaAs,
- une couche p+ (12) présentant une face supérieure, une face inférieure et comprenant un composé GaAs ou constituée de GaAs, et
- une première couche de contact métallique (26) et une deuxième couche de contact métallique (24), dans laquelle
- la première couche de contact métallique (26) est reliée par liaison de matière à la face inférieure de la couche de substrat n+ (22),
- la face inférieure de la zone n- (20) est disposée au-dessus de la face supérieure de la couche de substrat n+ (22), et
- la deuxième couche de contact métallique (24) est reliée par liaison de matière à la face supérieure de la couche p+ (12),
dans laquelle la face inférieure de la couche p- est disposée sur la face supérieure de la couche n- et la face inférieure de la couche p+ est disposée sur la face supérieure de la couche p-,
**caractérisée en ce que**
- une couche de masque dur (16) présentant une face supérieure, une face inférieure et au moins une ouverture de semence (18) est prévue, dans laquelle
- la face inférieure de la couche de masque dur (16) est reliée par liaison de matière à la face supérieure de la couche de substrat n+ (22),
- la zone n- (20) s'étend à l'intérieur de l'ouverture de semence (18) et sur une zone de bord (42) de la face supérieure de la couche de masque dur (16) à proximité de l'ouverture de semence (18), et
- la zone n- (20) à l'intérieur de l'ouverture de semence (18) est reliée par liaison de matière à la face supérieure de la couche de substrat n+ (22) et dans la zone de bord (42) de la face supérieure de la couche de masque dur à la couche de masque dur.

3. Diode en forme de pile à semi-conducteur de puissance III-V à blocage élevé (10) selon la revendication 1, **caractérisée en ce que** la couche de substrat p+ (12) présente une concentration de dopant qui est comprise entre 5•10¹⁸ cm⁻³ et 5•10²⁰ cm⁻³ et une épaisseur de couche (D12) qui est comprise entre 5 µm et 300 µm.

4. Diode en forme de pile à semi-conducteur de puissance III-V à blocage élevé (10) selon la revendication 1 ou 3, **caractérisée en ce que** la couche n+ (22) présente une concentration de dopant qui est égale à au moins 1•10¹⁸ cm⁻³ et une épaisseur de couche (D22) qui est inférieure à 30 µm.

5. Diode en forme de pile à semi-conducteur de puissance III-V à blocage élevé (10) selon la revendication 1 ou 3 ou 4, **caractérisée en ce que** la couche n+ (22) recouvre la zone n- (20) entièrement ou au moins à 95 % et la deuxième couche de contact métallique (24) recouvre la couche n+ (22) entièrement ou au moins à 95%.

6. Diode en forme de pile à semi-conducteur de puissance III-V à blocage élevé (10) selon la revendication 2, **caractérisée en ce que** la couche de substrat n+ (22) présente une concentration de dopant qui est égale à au moins 1•10¹⁸ cm⁻³ et une épaisseur de couche (D22) qui est comprise entre 5 µm et 300 µm.

7. Diode en forme de pile à semi-conducteur de puissance III-V à blocage élevé (10) selon la revendication 2 ou 6, **caractérisée en ce que** la couche p+ (12) présente une concentration de dopant qui est comprise entre 5•10¹⁸ cm⁻³ et 5•10²⁰ cm⁻³ et une épaisseur de couche (D12) qui est inférieure à 30 µm.

8. Diode en forme de pile à semi-conducteur de puissance III-V à blocage élevé (10) selon la revendication 2 ou 6 ou 7, **caractérisée en ce que** la couche p+ (12) recouvre la zone n- (20) entièrement ou au moins à 95 % et la deuxième couche de contact métallique (24) recouvre la couche p+ (12) entièrement ou au moins à 95%.

9. Diode en forme de pile à semi-conducteur de puissance III-V à blocage élevé (10) selon l'une quelconque des revendications précédentes, **caractérisée en ce que** la zone n- (20) au-dessus de la couche de masque dur (16) présente un premier diamètre et l'ouverture de semence (18) présente un second diamètre, dans laquelle le premier diamètre est plus grand que le second diamètre au moins d'un facteur 1,5.

10. Diode en forme de pile à semi-conducteur de puissance III-V à blocage élevé (10) selon l'une quelconque des revendications précédentes, **caractérisée en ce que** l'ouverture de semence (18) est réalisée de manière rectangulaire et présente une largeur (D18) et une longueur.

11. Diode en forme de pile à semi-conducteur de puissance III-V à blocage élevé (10) selon la revendication 6, **caractérisée en ce que** la largeur de l'ouverture de semence (18) s'étend parallèlement à la direction <011> ou <001> ou <111> ou selon un angle de 15° ou de 30° par rapport à la direction <011> ou par rapport à la direction <001> ou par rapport à la direction <111> de la couche de substrat.

12. Diode en forme de pile à semi-conducteur de puissance III-V à blocage élevé (10) selon l'une quelconque des revendications précédentes, **caractérisée en ce que** la face supérieure de la couche de substrat est réalisée sous la forme d'une surface de GaAs(100) ou d'une surface de GaAs(111).

13. Diode en forme de pile à semi-conducteur de puissance III-V à blocage élevé (10) selon l'une quelconque des revendications précédentes, **caractérisée en ce qu'**au moins une des couches de type p comprend du zinc.

14. Diode en forme de pile à semi-conducteur de puissance III-V à blocage élevé (10) selon l'une quelconque des revendications précédentes, **caractérisée en ce qu'**au moins une des couches de type n comprend du silicium et/ou du chrome et/ou du palladium et/ou de l'étain.

15. Diode en forme de pile à semi-conducteur de puissance III-V à blocage élevé (10) selon l'une quelconque des revendications précédentes, **caractérisée en ce que**, à l'exception de la couche de substrat, la totalité des couches de la diode en forme de pile à semi-conducteur de puissance III-V sont produites de manière épitaxique sur la couche respectivement précédente.

16. Diode en forme de pile à semi-conducteur de puissance III-V à blocage élevé (10) selon l'une quelconque des revendications précédentes, **caractérisée en ce que** la couche de masque dur (16) est constituée de SiO₂ et/ou de Si₃N₄.

17. Diode en forme de pile à semi-conducteur de puissance III-V à blocage élevé (10) selon l'une quelconque des revendications précédentes, **caractérisée en ce que** la couche de masque dur (16) présente une épaisseur de couche qui est comprise entre 0,1 µm et 5 µm.

18. Diode en forme de pile à semi-conducteur de puissance III-V à blocage élevé (10) selon l'une quelconque des revendications précédentes, **caractérisée en ce qu'**un tracé conducteur (28) est disposé sur la face supérieure de la couche de masque dur (16) et le tracé conducteur (28) est relié à la deuxième couche de contact métallique (24).

19. Diode en forme de pile à semi-conducteur de puissance III-V à blocage élevé (10) selon l'une quelconque des revendications précédentes, **caractérisée en ce que** la couche p- (14) présente une concentration de dopant qui est comprise entre 1•10¹⁴ cm⁻³ et 1•10¹⁷ cm⁻³ et une épaisseur de couche (D14) qui est comprise entre 1 µm et 20 µm.

20. Diode en forme de pile à semi-conducteur de puissance III-V à blocage élevé (10) selon l'une quelconque des revendications précédentes, **caractérisée en ce que** la zone n- (20) présente une concentration de dopant qui est comprise entre 8•10¹³ cm⁻³ et 1•10¹⁶ cm⁻³.
